# EUROPEAN PATENT APPLICATION

(11) **EP 4 729 722 A1**
(43) Date of publication of application: **22.04.2026**
(21) Application number: 25207487.7
(22) Date of filing: 08.10.2025
(51) Int. Cl.: E05B 17/10, B60J 5/04, E05B 81/76, E05B 81/78

(54) **VEHICLE OUTER PANEL ASSEMBLY**

(30) Priority: 21.10.2024 JP 2024185277
(71) Applicant: TOYOTA JIDOSHA KABUSHIKI KAISHA, Toyota-shi, Aichi-ken 471-8571 (JP)
(72) Inventor: SHIMIZU, Tatsuya, TOYOTA-SHI, AICHI-KEN, 471-8571 (JP); HYODO, Hiroki, TOYOTA-SHI, AICHI-KEN, 471-8571 (JP)
(74) Representative: Cabinet Beau de Loménie

(57) **Abstract**

A vehicle outer panel assembly (110) including a resin rear door outer panel (31) and an electrostatic capacitive touch sensor (40) that detects contact with a design surface (31A) of the rear door outer panel (31) is provided. The electrostatic capacitive touch sensor (40) is provided on the inner side of the rear door outer panel (31).

## Description

### BACKGROUND OF THE INVENTION

### 1. Field of the Invention

The present disclosure relates to a structure of a vehicle outer panel assembly.

### 2. Description of Related Art

Technologies that perform locking and unlocking of a vehicle using an electrostatic capacitive sensor have been disclosed. For example, Japanese Unexamined Patent Application Publications No. 2015-200117 (JP 2015-200117 A), No. 2017-20243 (JP 2017-20243 A), and No. 2008-208593 (JP 2008-208593 A) disclose configurations in which an electrostatic capacitive locking sensor and an unlocking sensor are mounted in a door handle for a vehicle to perform locking and unlocking of a door.

### SUMMARY OF THE INVENTION

Incidentally, electrostatic capacitive sensors cannot be disposed on a steel sheet because of the possibility of false detection due to current conduction. In the doors of the related art described in JP 2015-200117 A, JP 2017-20243 A, and JP 2008-208593 A, therefore, the sensors need to be provided in the resin door handle. Thus, the doors of the related art have limited flexibility in disposing the sensors.

In view of this, the present disclosure provides a technology that improves the flexibility in disposing an electrostatic capacitive sensor.

An aspect of the present disclosure relates to a vehicle outer panel assembly including a resin outer panel and an electrostatic capacitive touch sensor. The electrostatic capacitive touch sensor detects contact with a design surface of the outer panel. The electrostatic capacitive touch sensor is provided on the inner side of the outer panel.

The vehicle outer panel assembly of the aspect as described above allows the electrostatic capacitive touch sensor to be installed anywhere on the resin outer panel, and can thereby improve the flexibility in disposing the electrostatic capacitive touch sensor.

In the vehicle outer panel assembly of the aspect of the present disclosure, the outer panel may include a door outer panel constituting a door. The outer panel may include a door handle provided on the door outer panel. The electrostatic capacitive touch sensor may be provided at a position other than in the door handle.

The vehicle outer panel assembly of the configuration as described above allows the electrostatic capacitive touch sensor to be installed anywhere on the resin door outer panel other than in the door handle, and can thereby improve the flexibility in disposing the electrostatic capacitive touch sensor.

In the vehicle outer panel assembly of the configuration as described above, the outer panel may include a rear door outer panel constituting a rear door on the vehicle rear side. The outer panel may include a rear door handle provided on the rear door outer panel. The electrostatic capacitive touch sensor may be provided on the inner side of the rear door outer panel, in front of the rear door handle in a vehicle front-rear direction.

The vehicle outer panel assembly of the configuration as described above eliminates the need to install separate electrostatic capacitive touch sensors in the door handle of the front door and the door handle of the rear door. Thus, the number of electrostatic capacitive touch sensors to be installed can be reduced to simplify the configuration.

In the vehicle outer panel assembly of the configuration as described above, the outer panel may include a front door outer panel constituting a front door on the vehicle front side. The outer panel may include a front door handle provided on the front door outer panel. The electrostatic capacitive touch sensor may be provided on the inner side of the front door outer panel, behind the front door handle in the vehicle front-rear direction.

The vehicle outer panel assembly of the configuration as described above eliminates the need to install separate electrostatic capacitive touch sensors in the door handle of the front door and the door handle of the rear door. Thus, the number of electrostatic capacitive touch sensors to be installed can be reduced to simplify the configuration.

In the vehicle outer panel assembly of the aspect of the present disclosure, the outer panel may include a door outer panel constituting a door. The outer panel may include a door handle provided on the door outer panel. The electrostatic capacitive touch sensor may be provided at a level in a vehicle-height direction that is near the level of the door handle.

The vehicle outer panel assembly of the configuration as described above makes it possible to provide the electrostatic capacitive touch sensor at a place easily accessible for a user to improve the user-friendliness, while improving the flexibility in disposing the electrostatic capacitive touch sensor.

In the vehicle outer panel assembly of the aspect of the present disclosure, the outer panel may be a pillar outer panel constituting a pillar. The electrostatic capacitive touch sensor may be provided on the inner side of the pillar outer panel.

The vehicle outer panel assembly of the configuration as described above makes it possible to provide the electrostatic capacitive touch sensor at a place easily accessible for a user to improve the user-friendliness, while improving the flexibility in disposing the electrostatic capacitive touch sensor.

In the vehicle outer panel assembly of the aspect of the present disclosure, the outer panel may include, on a design surface, a sign that indicates a position of the electrostatic capacitive touch sensor.

The vehicle outer panel assembly of the configuration as described above includes the sign on the door outer panel and thus can improve the visibility for the user.

In the vehicle outer panel assembly of the aspect and the configuration of the present disclosure, the outer panel may have a light-permeable part at a position where the electrostatic capacitive touch sensor is disposed. The outer panel may include a light source disposed on the inner side of the outer panel.

The vehicle outer panel assembly of the configuration as described above can improve the visibility for the user.

In the vehicle outer panel assembly of the aspect and the configuration as described above, the electrostatic capacitive touch sensor may be a locking sensor that accepts a locking operation of a vehicle.

The vehicle outer panel assembly of the configuration as described above can improve the flexibility in disposing the locking sensor.

In the vehicle outer panel assembly of the aspect of the present disclosure, the outer panel may be a sliding door outer panel constituting a sliding door. The outer panel may include a sliding door handle provided on the sliding door outer panel. The electrostatic capacitive touch sensor may be an opening-closing sensor that is provided at a position other than in the sliding door handle and accepts opening and closing operations of the sliding door.

The vehicle outer panel assembly of the configuration as described above can improve the flexibility in disposing the opening-closing sensor of the sliding door.

The vehicle outer panel assembly of the present disclosure can improve the flexibility in disposing an electrostatic capacitive sensor.

### BRIEF DESCRIPTION OF THE DRAWINGS

Features, advantages, and technical and industrial significance of exemplary embodiments of the invention will be described below with reference to the accompanying drawings, in which like signs denote like elements, and wherein:
FIG. 1 is a right-side view of a vehicle including a vehicle outer panel assembly of a first embodiment of the present disclosure;
FIG. 2 is a sectional view of a rear door shown in FIG. 1, and is a section II-II shown in FIG. 1;
FIG. 3 is a side view of the rear door, and is a detailed view of a part B shown in FIG. 1;
FIG. 4 is a sectional view of the rear door including a vehicle outer panel assembly of a second embodiment of the present disclosure;
FIG. 5 is a section V-V shown in FIG. 4;
FIG. 6 is a right-side view of a vehicle including a vehicle outer panel assembly of a third embodiment of the present disclosure, and is a view showing an arrangement of electrostatic capacitive touch sensors and marks;
FIG. 7 is a view showing a mark different from the marks shown in FIG. 6;
FIG. 8 is a sectional view of a rear door of a vehicle including a vehicle outer panel assembly of a fourth embodiment of the present disclosure; and
FIG. 9 is a right-side view of a vehicle including a vehicle outer panel assembly of a fifth embodiment of the present disclosure.

### DETAILED DESCRIPTION OF EMBODIMENTS

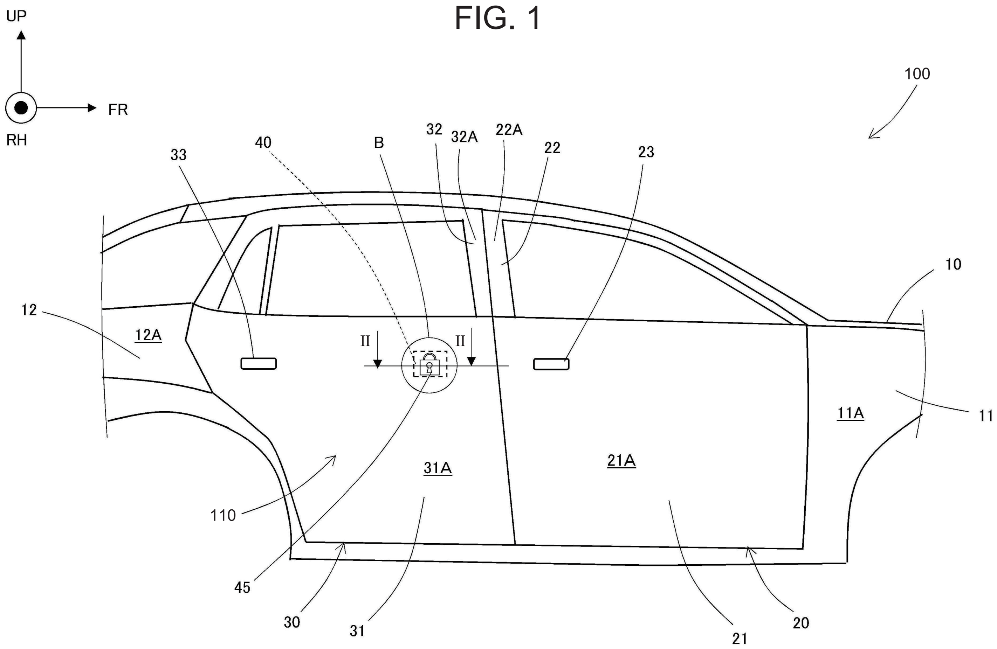

In the following, a vehicle outer panel assembly 110 of a first embodiment will be described with reference to the drawings. The vehicle outer panel assembly 110 of the first embodiment includes a front door outer panel 21 of a front door 20 and a rear door outer panel 31 of a rear door 30. The front door outer panel 21 and the rear door outer panel 31 will be collectively referred to as a door outer panel. In the vehicle outer panel assembly 110, an electrostatic capacitive touch sensor 40 is provided on an inner side of the rear door outer panel 31. FIG. 1 is a right-side view of a vehicle 100 including the vehicle outer panel assembly 110 of the first embodiment. FR, UP, and RH shown in each drawing indicate a front side, an upper side, and a right-side, respectively, of the vehicle 100. Directions opposite from FR, UP, and RH indicate a rear side, a lower side, and a left side. Unless otherwise noted, when the directions of simply front-rear, right-left, and up-down are used in the following description, these directions indicate front-rear, right-left, and up-down of the vehicle 100.

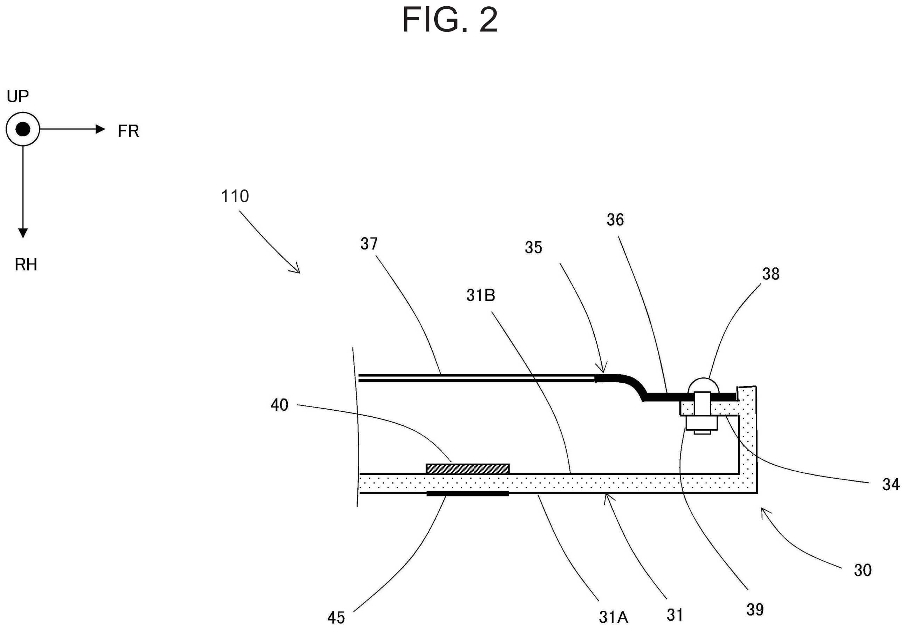

First, a configuration of the vehicle 100 will be described with reference to FIG. 1 and FIG. 2. The vehicle 100 includes a body 10, the front door 20, and the rear door 30. The body 10 is formed by mounting outer panels, including a resin front fender panel 11 and a resin rear fender panel 12, to an outer side of a metal frame (not shown). An outer surface of the front fender panel 11 constitutes a design surface 11A of the front fender panel 11, and an outer surface of the rear fender panel 12 constitutes a design surface 12A of the rear fender panel 12.

The rear door 30 is a hinged door of which a front end portion is rotatably mounted on a frame by a hinge and a rear end portion opens and closes toward a lateral side of the vehicle 100. The rear door 30 includes a metal rear door frame 35 (see FIG. 2), the resin rear door outer panel 31, a rear door handle 33, the electrostatic capacitive touch sensor 40, and a mark 45. The rear door frame 35 is an annular folded plate member having an opening 37 at a center. As shown in FIG. 2, the rear door outer panel 31 includes, at an outer peripheral portion, an inner flange 34 that protrudes toward an inside. The inner flange 34 is mounted on a peripheral edge portion 36 of the rear door frame 35 by a bolt 38 and a nut 39. An outer surface of the rear door outer panel 31 constitutes a design surface 31A of the rear door outer panel 31.

The electrostatic capacitive touch sensor 40 is an electrostatic capacitive sensor that detects contact with the design surface 31A of the rear door outer panel 31. The electrostatic capacitive touch sensor 40 is a locking sensor that accepts a locking operation of the vehicle 100. As shown in FIG. 1, the electrostatic capacitive touch sensor 40 is disposed at a position in front of the rear door handle 33 in a vehicle front-rear direction, at a level in a vehicle-height direction that is near the level of the rear door handle 33. As shown in FIG. 2, the electrostatic capacitive touch sensor 40 is mounted on an inner surface 31B of the rear door outer panel 31, at a position where the electrostatic capacitive touch sensor 40 does not overlap the peripheral edge portion 36 of the rear door frame 35 when seen from a vehicle-width direction.

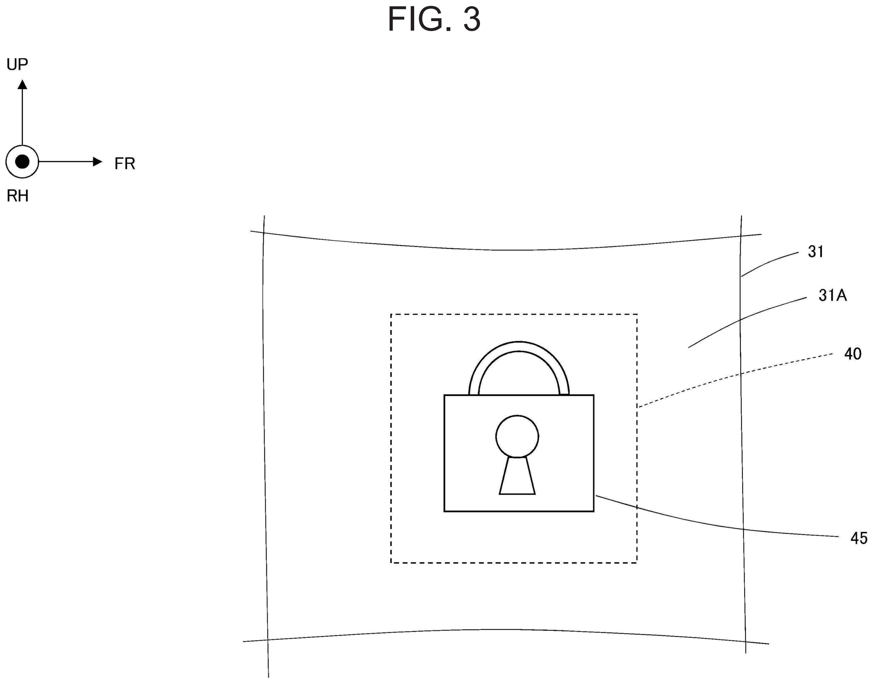

The mark 45 is a sign that indicates the position of the electrostatic capacitive touch sensor 40. The mark 45 is provided on the design surface 31A, at the position where the electrostatic capacitive touch sensor 40 is disposed. While the shape of the mark 45 can be freely selected, it may be, for example, a shape resembling a padlock as shown in FIG. 3.

The rear door outer panel 31, the rear door handle 33, the electrostatic capacitive touch sensor 40, and the mark 45 having been described above compose the vehicle outer panel assembly 110 of the first embodiment.

While in the above description the electrostatic capacitive touch sensor 40 has been described as being disposed at a position in front of the rear door handle 33 in the vehicle front-rear direction, at a level in the vehicle-height direction that is near the level of the rear door handle 33, the present disclosure is not limited thereto. Since a part of the rear door 30 other than the rear door handle 33 is formed by the resin rear door outer panel 31, the electrostatic capacitive touch sensor 40 can be disposed at an arbitrary position on the inner surface 31B of the rear door outer panel 31 other than in the rear door handle 33. In this case, the vehicle outer panel assembly 110 is composed of the rear door outer panel 31, the electrostatic capacitive touch sensor 40, and the mark 45. When the mark 45 is not provided, the vehicle outer panel assembly 110 is composed of the rear door outer panel 31 and the electrostatic capacitive touch sensor 40.

As has been described above, in the vehicle outer panel assembly 110 of the first embodiment, the electrostatic capacitive touch sensor 40 is disposed on the inner surface 31B of the resin rear door outer panel 31. Thus, it is possible to improve the flexibility in disposing the electrostatic capacitive touch sensor 40 while inhibiting the electrostatic capacitive touch sensor 40 from falsely detecting contact due to current conduction from a metal part, such as the rear door frame 35.

With the increased flexibility in disposing the electrostatic capacitive touch sensor 40, the electrostatic capacitive touch sensor 40 can be provided at a position in front of the rear door handle 33 in the vehicle front-rear direction, at a level in the vehicle-height direction that is near the level of the rear door handle 33. This position is a position easily accessible for a user and can thus improve the user-friendliness. Moreover, since this position is a position midway between the front door handle 23 of the front door 20 and the rear door handle 33 of the rear door 30, there is no need to install separate electrostatic capacitive touch sensors 40 for the front door handle 23 and the rear door handle 33. Thus, the number of electrostatic capacitive touch sensors 40 to be installed can be reduced to simplify the configuration. Here, the front door handle 23 and the rear door handle 33 will be collectively referred to as a door handle.

In the vehicle outer panel assembly 110, since the electrostatic capacitive touch sensor 40 is mounted at a position where it does not overlap the peripheral edge portion 36 of the metal rear door frame 35 when seen from the vehicle-width direction, the electrostatic capacitive touch sensor 40 can be inhibited from falsely detecting contact due to current conduction from the peripheral edge portion 36.

While in the above description the electrostatic capacitive touch sensor 40 has been described as being mounted on the inner surface 31B of the rear door outer panel 31, the present disclosure is not limited thereto. As long as the electrostatic capacitive touch sensor 40 is provided on the inner side of the rear door outer panel 31 so as to be able to detect contact with the design surface 31A, the electrostatic capacitive touch sensor 40 may be mounted on the inner surface 31B through a film member, for example, instead of being directly mounted on the inner surface 31B.

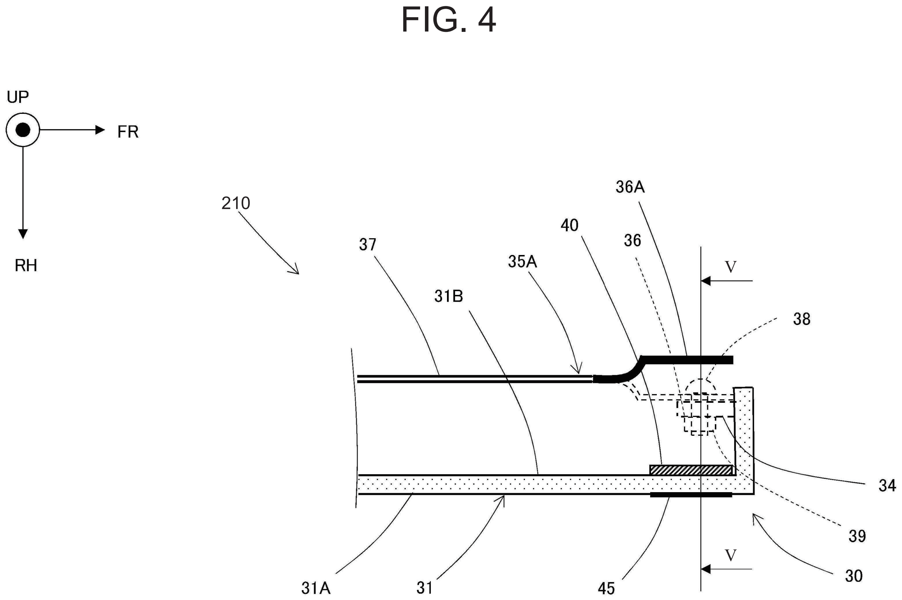

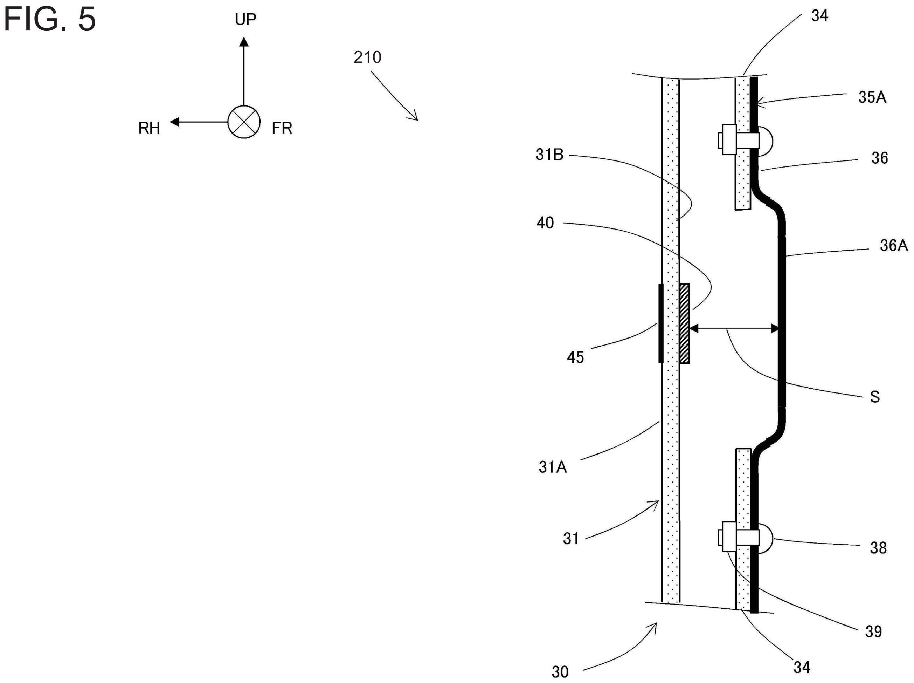

Next, a vehicle outer panel assembly 210 of a second embodiment will be described with reference to FIG. 4 and FIG. 5. Those parts that are the same as in the vehicle outer panel assembly 110 of the first embodiment described earlier with reference to FIGS. 1 to 3 will be denoted by the same reference signs and description thereof will be omitted. As shown in FIG. 4, in the vehicle outer panel assembly 210, the electrostatic capacitive touch sensor 40 is disposed on the inner surface 31B of an outer peripheral portion of the rear door outer panel 31.

As shown in FIG. 4 and FIG. 5, a part of the peripheral edge portion 36 where the electrostatic capacitive touch sensor 40 is disposed is a recessed part 36A where the peripheral edge portion 36 is bent away from the inner surface 31B. A gap S between the electrostatic capacitive touch sensor 40 and the recessed part 36A should have such a length that false detection due to current conduction from the recessed part 36A does not occur. Another recessed part (not shown) for securing the gap S with respect to the electrostatic capacitive touch sensor 40 may be provided at a part of the rear door frame 35 other than the peripheral edge portion 36.

Thus, in the vehicle outer panel assembly 210, when the metal rear door frame 35 and the electrostatic capacitive touch sensor 40 are near each other, the recessed part 36A for securing the gap S with respect to the electrostatic capacitive touch sensor 40 is provided in the rear door frame 35, which allows the electrostatic capacitive touch sensor 40 to be disposed also on the inner surface 31B of the outer peripheral portion of the rear door outer panel 31. This makes it possible to further improve the flexibility in disposing the electrostatic capacitive touch sensor 40 while inhibiting the electrostatic capacitive touch sensor 40 from falsely detecting contact due to current conduction from a metal part, such as the rear door frame 35.

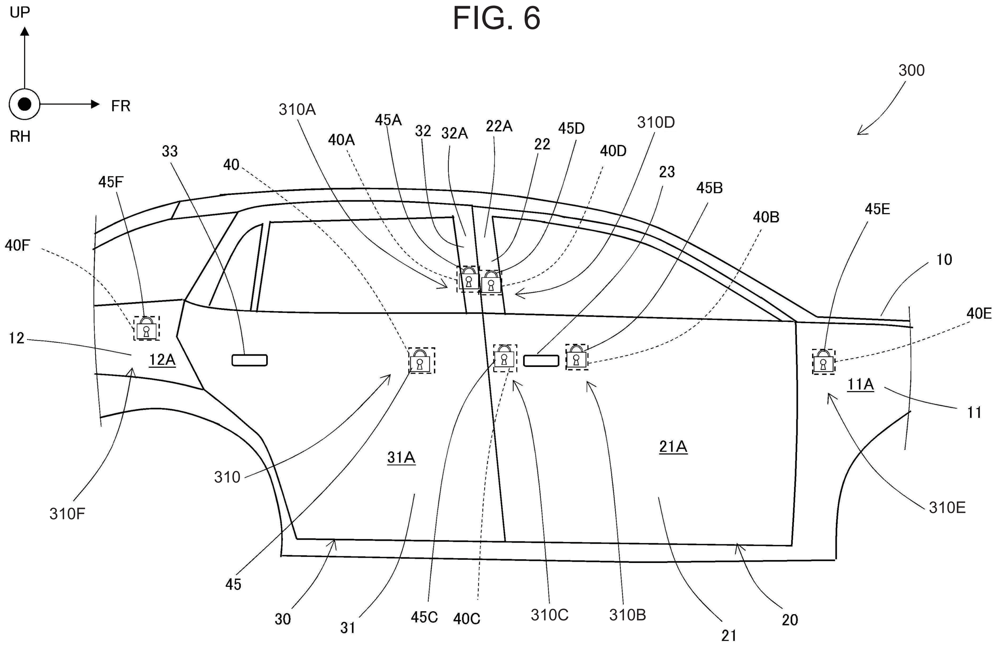

Next, a vehicle outer panel assembly 310 of a third embodiment will be described with reference to FIG. 6. Those components that are the same as in the vehicle outer panel assembly 110 described earlier with reference to FIGS. 1 to 3 will be briefly described. A vehicle 300 includes the vehicle outer panel assembly 310 and one or more among vehicle outer panel assemblies 310A to 310F to be described below, and need not include all of the vehicle outer panel assemblies 310, 310A to 310F.

In the vehicle outer panel assembly 310A shown in FIG. 6, an electrostatic capacitive touch sensor 40A is mounted on an inner side of a pillar outer panel 32 of the rear door 30.

A metal pillar frame (not shown) constituting an outer frame of a center pillar part of the rear door 30 is connected to an upper portion of the rear door frame 35. The pillar outer panel 32 is mounted on the pillar frame by a clip etc. An outer surface of the pillar outer panel 32 constitutes a design surface 32A of the center pillar part of the rear door 30. The electrostatic capacitive touch sensor 40A is mounted on an inner surface of the pillar outer panel 32. A mark 45A is provided on the design surface 32A, at the position where the electrostatic capacitive touch sensor 40A is disposed.

The pillar outer panel 32, the electrostatic capacitive touch sensor 40A, and the mark 45A compose the vehicle outer panel assembly 310A. When the mark 45A is not provided, the vehicle outer panel assembly 310A is composed of the pillar outer panel 32 and the electrostatic capacitive touch sensor 40A.

In the vehicle outer panel assemblies 310B, 310C, electrostatic capacitive touch sensors 40B, 40C, respectively, are mounted on an inner side of the front door outer panel 21 of the front door 20.

Like the rear door 30, the front door 20 is a hinged door of which a front end portion is rotatably mounted on a frame by a hinge and a rear end portion opens and closes toward the lateral side of the vehicle 300. The front door 20 includes a metal front door frame (not shown), the resin front door outer panel 21, and the front door handle 23. An outer surface of the front door outer panel 21 constitutes a design surface 21A of the front door outer panel 21. In the vehicle outer panel assembly 310B, the electrostatic capacitive touch sensor 40B is provided at a position in front of the front door handle 23, at a level in the vehicle-height direction that is near the level of the front door handle 23. In the vehicle outer panel assembly 310C, the electrostatic capacitive touch sensor 40C is provided at a position in an outer peripheral portion of the front door outer panel 21 behind the front door handle 23, at a level in the vehicle-height direction that is near the level of the front door handle 23. A mounting structure of the front door outer panel 21 onto the front door frame and a mounting structure of the electrostatic capacitive touch sensors 40B, 40C onto the front door outer panel 21 are the same as in the vehicle outer panel assembly 210 described with reference to FIG. 4 and FIG. 5. Marks 45B, 45C are provided at positions in the design surface 21A where the electrostatic capacitive touch sensors 40B, 40C, respectively, are disposed.

The front door outer panel 21, the electrostatic capacitive touch sensor 40B, the front door handle 23, and the mark 45B compose the vehicle outer panel assembly 310B. The front door outer panel 21, the electrostatic capacitive touch sensor 40C, the front door handle 23, and the mark 45C compose the vehicle outer panel assembly 310C.

As in the vehicle outer panel assembly 110 described earlier, the electrostatic capacitive touch sensors 40B, 40C can be disposed at arbitrary positions on the inner surface of the front door outer panel 21 other than in the front door handle 23. In this case, the vehicle outer panel assemblies 310B, 310C are composed of the front door outer panel 21, the electrostatic capacitive touch sensors 40B, 40C, and the marks 45B, 45C. When the marks 45B, 45C are not provided, the vehicle outer panel assemblies 310B, 310C are composed of the front door outer panel 21 and the electrostatic capacitive touch sensors 40B, 40C.

In the vehicle outer panel assembly 310D, as in the vehicle outer panel assembly 310A, an electrostatic capacitive touch sensor 40D is mounted on an inner side of a pillar outer panel 22 of the front door 20.

As with the rear door 30, a metal pillar frame (not shown) constituting an outer frame of a center pillar part of the front door 20 is connected to an upper portion of the front door frame (not shown). The pillar outer panel 22 is mounted on the pillar frame by a clip etc. An outer surface of the pillar outer panel 22 constitutes a design surface 22A of the center pillar part of the front door 20. The electrostatic capacitive touch sensor 40D is mounted on an inner surface of the pillar outer panel 22. A mark 45D is provided on the design surface 22A, at the position where the electrostatic capacitive touch sensor 40D is disposed.

The pillar outer panel 22, the electrostatic capacitive touch sensor 40D, and the mark 45D compose the vehicle outer panel assembly 310D. When the mark 45D is not provided, the vehicle outer panel assembly 310A is composed of the pillar outer panel 22 and the electrostatic capacitive touch sensor 40D.

In the vehicle outer panel assembly 310E, an electrostatic capacitive touch sensor 40E is mounted on an inner surface of the resin front fender panel 11. A mark 45E is provided on the design surface 11A, at the position where the electrostatic capacitive touch sensor 40E is disposed. The front fender panel 11, the electrostatic capacitive touch sensor 40E, and the mark 45E compose the vehicle outer panel assembly 310E. When the mark 45E is not provided, the vehicle outer panel assembly 310E is composed of the front fender panel 11 and the electrostatic capacitive touch sensor 40E.

In the vehicle outer panel assembly 310F, an electrostatic capacitive touch sensor 40F is mounted on an inner surface of the resin rear fender panel 12. A mark 45F is provided on the design surface 12A, at the position where the electrostatic capacitive touch sensor 40F is disposed. The rear fender panel 12, the electrostatic capacitive touch sensor 40F, and the mark 45F compose the vehicle outer panel assembly 310F. When the mark 45F is not provided, the vehicle outer panel assembly 310F is composed of the rear fender panel 12 and the electrostatic capacitive touch sensor 40F.

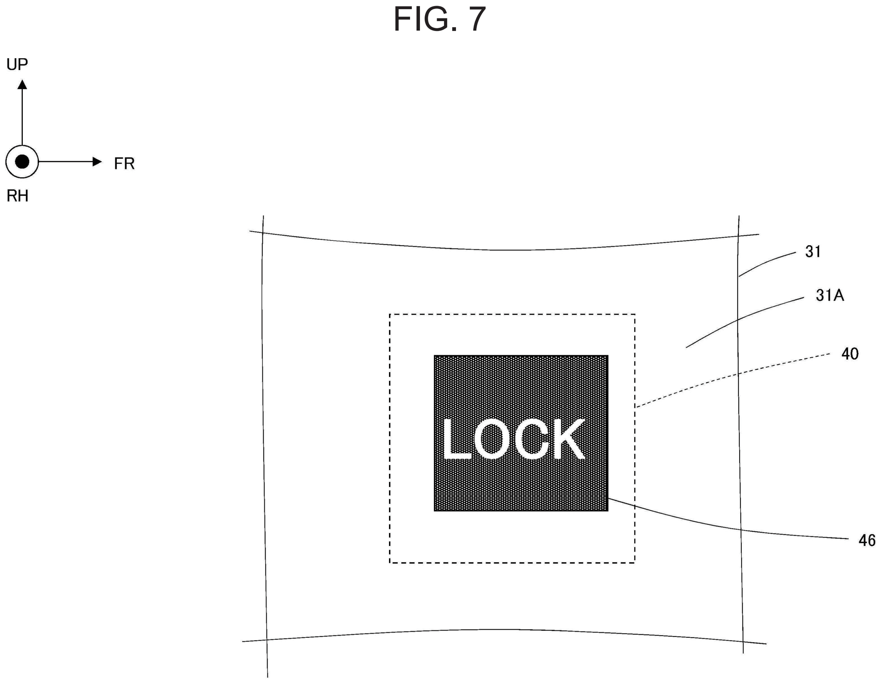

Next, a mark 46 of another form will be described with reference to FIG. 7. The mark 46 has white letters "LOCK" disposed on a black background. Like the mark 45, the mark 46 is disposed on the design surface 31A, at the position where the electrostatic capacitive touch sensor 40 is disposed.

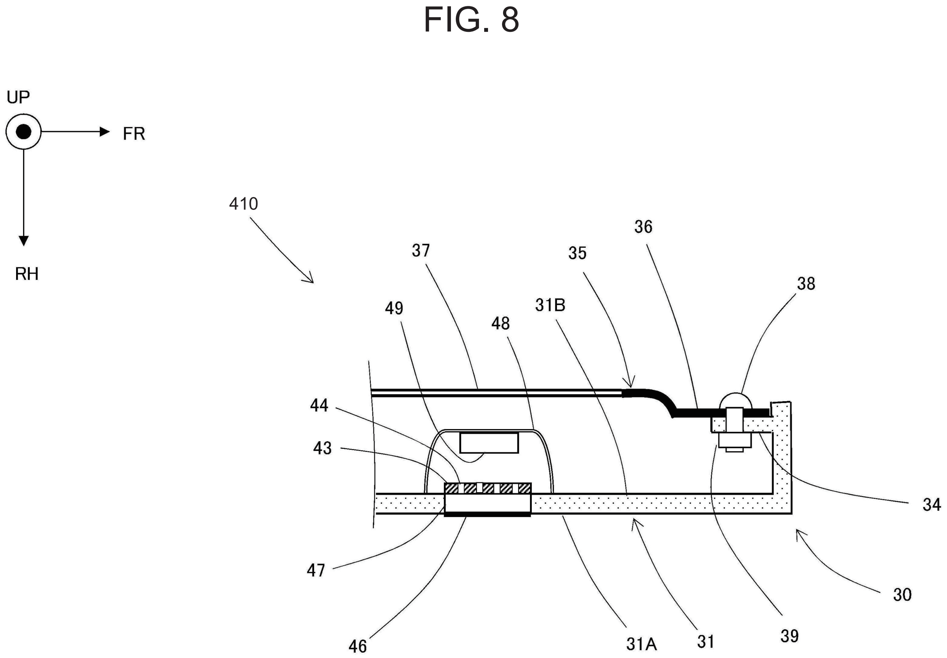

Next, a vehicle outer panel assembly 410 of a fourth embodiment will be described with reference to FIG. 8. Those parts that are the same as in the vehicle outer panel assembly 110 described earlier with reference to FIG. 1 to FIG. 3 will be denoted by the same reference signs and description thereof will be omitted.

As shown in FIG. 8, the rear door outer panel 31 includes a light-permeable part 47 at a position where an electrostatic capacitive touch sensor 43 is disposed. On the inner side of the rear door outer panel 31, a light source casing 48 is provided so as to surround the electrostatic capacitive touch sensor 43. Inside the light source casing 48, a light source 49 is disposed. The electrostatic capacitive touch sensor 43 includes a plurality of through-holes 44 through which light from the light source 49 passes. The through-holes 44 are disposed so as to align with the positions of the letters of the mark 46 described with reference to FIG. 7. The light source 49 may be formed by, for example, an LED. Thus, the letters of the mark 46 can be lighted by the light from the light source 49 to improve the visibility of the mark 46.

The rear door outer panel 31, the electrostatic capacitive touch sensor 43, the light-permeable part 47, the light source 49, and the mark 46 compose the vehicle outer panel assembly 410. When the mark 46 is not included and the position of the electrostatic capacitive touch sensor 43 is indicated through lighting by the light source 49, the vehicle outer panel assembly 410 is composed of the rear door outer panel 31, the electrostatic capacitive touch sensor 43, the light-permeable part 47, and the light source 49.

While in the above description the electrostatic capacitive touch sensor 43 has been described as including the through-holes 44, the present disclosure is not limited thereto, and the electrostatic capacitive touch sensor 43 may be formed by a translucent member and not include the through-holes 44.

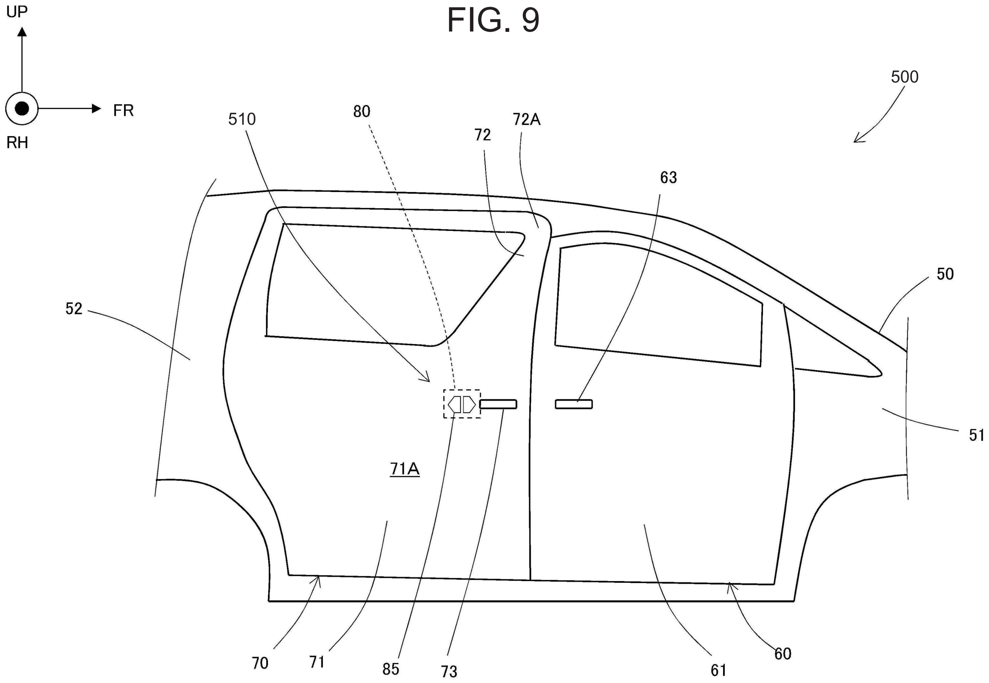

Next, a vehicle outer panel assembly 510 of a fifth embodiment will be described with reference to FIG. 9. Those parts that are the same as in the vehicle outer panel assembly 110 described earlier with reference to FIG. 1 to FIG. 3 will be briefly described.

The vehicle outer panel assembly 510 includes a front door outer panel 61 of a front door 60 and a sliding door outer panel 71 of a sliding door 70. Here, the sliding door outer panel corresponds to the above-described rear door outer panel. The front door outer panel 61 and the sliding door 70 will be collectively referred to as a door outer panel. In the vehicle outer panel assembly 510, an electrostatic capacitive touch sensor 80 is mounted on an inner side of the sliding door outer panel 71 of the sliding door 70 on the vehicle rear side. Here, the electrostatic capacitive touch sensor 80 is an opening-closing sensor that accepts opening and closing operations of the sliding door 70.

First, a vehicle 500 including the sliding door 70 will be briefly described. Like the vehicle 100 described earlier with reference to FIG. 1 and FIG. 2, the vehicle 500 includes a body 50, the front door 60 on the front side, and the sliding door 70 on the rear side. The body 50 is formed by mounting outer panels, including a resin front fender panel 51 and a resin rear fender panel 52, to an outer side of a metal frame (not shown).

The front door 60 on the vehicle front side is a hinged door of which a front end portion is rotatably mounted on a frame by a hinge and a rear end portion opens and closes toward a lateral side of the vehicle 500. The front door 60 includes a metal front door frame (not shown), the resin front door outer panel 61, and a front door handle 63.

The sliding door 70 on the vehicle rear side is a sliding-type door that slides in the vehicle front-rear direction. Like the rear door 30, the sliding door 70 includes a metal sliding door frame (not shown), the resin sliding door outer panel 71, a sliding door handle 73, an electrostatic capacitive touch sensor 80, and a mark 85. The sliding door outer panel 71 is mounted on the sliding door frame by a bolt etc. An outer surface of the sliding door outer panel 71 constitutes a design surface 71A of the sliding door outer panel 71.

The electrostatic capacitive touch sensor 80 is disposed at a position behind the sliding door handle 73 in the vehicle front-rear direction, at a level in the vehicle-height direction that is near the level of the sliding door handle 73. The electrostatic capacitive touch sensor 80 is mounted on an inner surface of the sliding door outer panel 71. The mark 85 that is a sign indicating the position of the electrostatic capacitive touch sensor 80 is provided on the sliding door outer panel 71, at the position where the electrostatic capacitive touch sensor 80 is disposed. The shape of the mark 85 can be freely selected. Since the electrostatic capacitive touch sensor 80 is an opening-closing sensor that accepts opening and closing operations of the sliding door 70, the mark 85 may be, for example, as shown in FIG. 9, a combination of two figures: one is a pentagonal front-side figure with a pointed leading end facing frontward and the other is a pentagonal rear-side figure with a pointed leading end facing rearward. Here, the leading end of the front-side figure indicates a closing direction of the sliding door 70, and the leading end of the rear-side figure indicates an opening direction of the sliding door 70.

As in the vehicle outer panel assembly 110 described earlier with reference to FIGS. 1 to 3, as long as the electrostatic capacitive touch sensor 80 is provided on the inner side of the sliding door outer panel 71 so as to be able to detect contact with the design surface 71A, the electrostatic capacitive touch sensor 80 may be mounted on the inner surface through a film member, for example, instead of being directly mounted on the inner surface.

The sliding door outer panel 71, the sliding door handle 73, the electrostatic capacitive touch sensor 80, and the mark 85 having been described above compose the vehicle outer panel assembly 510 of the fifth embodiment.

The vehicle outer panel assembly 510 having been described above can improve the flexibility in disposing the electrostatic capacitive touch sensor 80 that is an opening-closing sensor that accepts opening and closing operations of the sliding door 70.

While in the above description the electrostatic capacitive touch sensor 80 has been described as being mounted on the inner surface of the sliding door outer panel 71, the present disclosure is not limited thereto and the electrostatic capacitive touch sensor 80 may be mounted on an inner surface of a resin pillar outer panel 72.

As has been described above, in the present disclosure, the electrostatic capacitive touch sensors 40, 40A to 40F, 80 can be installed anywhere on the resin outer panels 11, 12, 21, 22, 31, 32, 71, 72, which can improve the flexibility in disposing the electrostatic capacitive touch sensors 40, 40A to 40F, 80.

While in the above description the electrostatic capacitive touch sensors 40, 40A to 40D have been described as being provided on the rear door 30 or the front door 20, the present disclosure is not limited thereto. When a design surface of a back door or a luggage door is formed by a resin outer panel, the electrostatic capacitive touch sensor 40 may be mounted on an inner surface of the outer panel constituting the back door or the luggage door.

## Claims

1. A vehicle outer panel assembly (110; 210; 310; 410; 510), comprising:
an outer panel (11, 12; 21, 22; 31, 32; 51,52) made of resin; and
an electrostatic capacitive touch sensor (40; 40A, 40B, 40C, 40D, 40E, 40F; 43; 80) that detects contact with a design surface (31A; 71A) of the outer panel (11, 12; 21, 22; 31, 32; 51,52), wherein
the electrostatic capacitive touch sensor (40; 40A, 40B, 40C, 40D, 40E, 40F; 43; 80) is provided on an inner side of the outer panel (11, 12; 21, 22; 31, 32; 51,52).

2. The vehicle outer panel assembly (110; 210; 310; 410; 510) according to claim 1, wherein:
the outer panel (11, 12; 21, 22; 31, 32; 51,52) includes a door outer panel (21, 31; 61, 71) constituting a door;
the outer panel (11, 12; 21, 22; 31, 32; 51,52) includes a door handle (23, 33; 63, 73) provided on the door outer panel (21, 31; 61, 71); and
the electrostatic capacitive touch sensor (40; 40A, 40B, 40C, 40D, 40E, 40F; 43; 80) is provided at a position other than in the door handle (23, 33; 63, 73).

3. The vehicle outer panel assembly (110; 210; 310; 410) according to claim 2, wherein:
the outer panel (11, 12; 21, 22; 31, 32) includes a rear door outer panel (31) constituting a rear door on a vehicle rear side;
the outer panel (11, 12; 21, 22; 31, 32) includes a rear door handle (33) provided on the rear door outer panel (31); and
the electrostatic capacitive touch sensor (40; 40A, 40B, 40C, 40D, 40E, 40F; 43) is provided on an inner side of the rear door outer panel (31), in front of the rear door handle (33) in a vehicle front-rear direction.

4. The vehicle outer panel assembly (310) according to claim 2, wherein:
the outer panel (31, 32) includes a front door outer panel (21) constituting a front door on a vehicle front side;
the outer panel (31, 32) includes a front door handle (23) provided on the front door outer panel (21); and
the electrostatic capacitive touch sensor (40C) is provided on an inner side of the front door outer panel (21), behind the front door handle (23) in a vehicle front-rear direction.

5. The vehicle outer panel assembly (110; 210; 310; 410) according to claim 1, wherein:
the outer panel (11, 12; 21, 22; 31, 32) includes a door outer panel (21, 31) constituting a door;
the outer panel (11, 12; 21, 22; 31, 32) includes a door handle (23, 33) provided on the door outer panel (21, 31); and
the electrostatic capacitive touch sensor (40; 40A, 40B, 40C, 40D, 40E, 40F; 43) is provided at a level in a vehicle-height direction that is near a level of the door handle (23, 33).

6. The vehicle outer panel assembly (310) according to claim 1, wherein:
the outer panel (31, 32) is a pillar outer panel (22, 32) constituting a pillar; and
the electrostatic capacitive touch sensor (40A, 40D) is provided on an inner side of the pillar outer panel (22, 32).

7. The vehicle outer panel assembly (110; 210; 310; 410; 510) according to any one of claims 1 to 6, wherein the outer panel (11, 12; 21, 22; 31, 32; 51,52) includes, on a design surface (31A; 71A), a sign (45; 45A, 45B, 45C, 45D, 45E, 45F; 46; 85) that indicates a position of the electrostatic capacitive touch sensor (40; 40A, 40B, 40C, 40D, 40E, 40F; 43; 80).

8. The vehicle outer panel assembly (410) according to any one of claims 1 to 6, wherein:
the outer panel (11, 12; 21, 22; 31, 32) includes a light-permeable part (47) at a position where the electrostatic capacitive touch sensor (43) is disposed; and
the outer panel (11, 12; 21, 22; 31, 32) includes a light source (49) disposed on the inner side of the outer panel (11, 12; 21, 22; 31, 32).

9. The vehicle outer panel assembly (110; 210; 310; 410; 510) according to claim 8, wherein the electrostatic capacitive touch sensor (40; 40A, 40B, 40C, 40D, 40E, 40F; 43; 80) is a locking sensor that accepts a locking operation of a vehicle.

10. The vehicle outer panel assembly (110; 210; 310; 410; 510) according to any one of claims 1 to 6, wherein the electrostatic capacitive touch sensor (40; 40A, 40B, 40C, 40D, 40E, 40F; 43; 80) is a locking sensor that accepts a locking operation of a vehicle.

11. The vehicle outer panel assembly (510) according to claim 1, wherein:
the outer panel (51,52) includes a sliding door outer panel (71) constituting a sliding door (70);
the outer panel (51,52) includes a sliding door handle (73) provided on the sliding door outer panel (71); and
the electrostatic capacitive touch sensor (80) is an opening-closing sensor that is provided at a position other than in the sliding door handle (73) and accepts opening and closing operations of the sliding door (70).
